# EUROPEAN PATENT APPLICATION

(11) **EP 1 521 300 A1**
(43) Date of publication of application: **06.04.2005**
(21) Application number: 03425642.0
(22) Date of filing: 30.09.2003
(51) Int. Cl.: H01L 21/768, H01L 23/522, H01L 23/532

(54) **Circuit structure integrated on a semiconductor substrate and relevant manufacturing method**

(71) Applicant: STMicroelectronics S.r.l., 20041 Agrate Brianza (Milano) (IT)
(72) Inventor: Zanotti, Luca, 20041 Agrate Brianza (Milano) (IT)
(74) Representative: Ferrari, Barbara

(57) **Abstract**

A circuit structure (1) integrated on a semiconductor substrate (2) comprising a plurality of electronic devices (3) covered by a first insulating layer (4), wherein said first dielectric layer (4) is covered by a closing layer (5) whereon a plurality of conductive interconnection levels are realised, being electrically connected to each other and separated from each other by means of a single insulating layer (13).

## Description

### Field of application

The present invention relates to a circuit structure integrated on a semiconductor substrate, particularly with a single intra- and intermetal dielectric layer.

More specifically, the invention relates to a circuit structure integrated on a semiconductor substrate comprising a plurality of electronic devices covered with a first insulating layer.

The invention also relates to a manufacturing process for realising a circuit structure integrated on a semiconductor substrate including a plurality of electronic devices comprising at least the step of:
- forming a first insulating layer on said plurality of electronic devices.
   The invention particularly relates, but not exclusively, to a circuit structure equipped with a single insulating layer between different interconnection levels provided therein and the following description is made with reference to this field of application for convenience of illustration only.

### Prior art

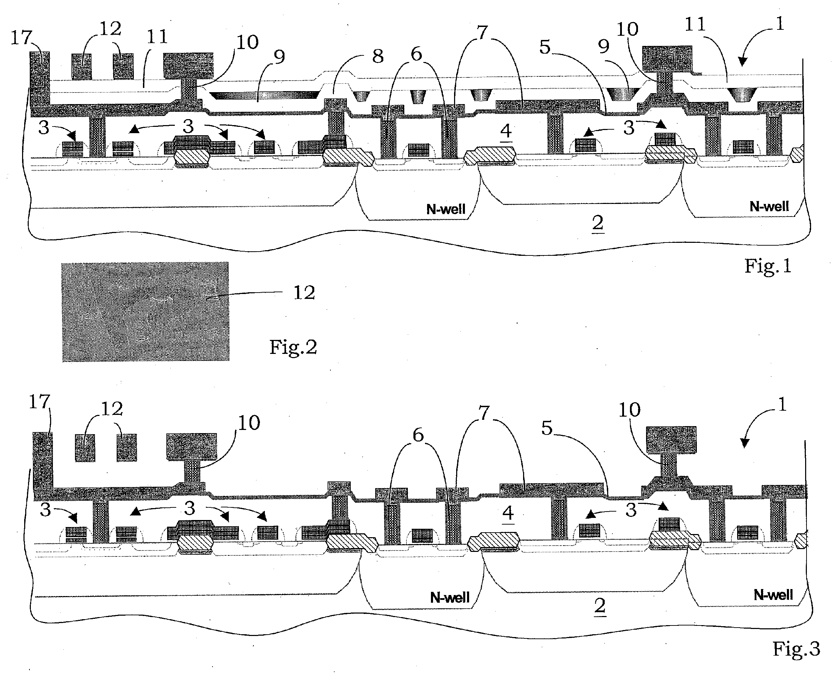

As it is well known, an electronic circuit structure 1 integrated on a semiconductor substrate 2 can include a plurality of electronic devices 3, for example transistors, diodes or resistors, formed on the same semiconductor substrate 2, as shown in figure 1.

The electronic components 3 are then covered by a first dielectric layer 4, called pre-metal dielectric.

The first dielectric layer 4 comprises openings located in correspondence with the conduction terminals of the electronic devices 3. A closing layer 5 called stopping layer completely coats these openings and it covers the first dielectric layer 4 forming a thin continuous film. This closing layer 5 is made for example of carbide or oxynitride or silicon nitride or the like having the same function.

The openings, called "contact" openings, are then filled in with a first metallic layer 6 to put the electronic devices 3 into electrical communication with the circuit structure 1 outside.

A first conductive interconnection level is then realised on the closing layer 5 by means of a second metallic layer 7.

This first conductive interconnection level is then covered by a second dielectric layer 8.

Possible depressions in this dielectric layer 8 are filled in with a further planarisation layer 9, for example through the Spin On Glass, "SOG", technique.

This second dielectric layer 8 is then covered by a third dielectric layer 11.

Openings, called "vias" are then realised in these second and third dielectric layers 8, 11, called intra/intermetal dielectrics, which openings are to be filled in with a third conductive layer 10 in correspondence with predetermined portions of the first conductive interconnection level.

A second conductive interconnection level is then realised on this latter dielectric layer 11 by means of a final metallic layer 12, as shown in figure 2.

These intra/intermetal dielectric layers 8, 11, as it is known, have the function of planarising the circuit structure 1 before forming the following different conductive interconnection levels.

The formation and following planarisation of each intra/intermetal dielectric layer 8, 11 is realised, for example, by forming an oxide or generally dielectric layer 8 and further forming a material layer 9 through the "Spin On Glass" technique. This planarising material layer can be for example of the organic or inorganic type or a combination of them. A partial or total etching step of this latter layer and of the underlying oxide layer then follows and after this operation the deposition of a second dielectric layer 11 is performed.

The formation and following planarisation of each intra/intermetal dielectric layer 8, 11 can be alternatively realised by forming these silicon dielectric layers through CVD (Chemical Vapour Deposition) followed by a CMP (Chemical Mechanical Polishing) planarisation step.

Being all the interconnections of the circuit structure 1 completed, which can be thus realised in a conventional way or through the "damascene" technique, the circuit structure 1 is covered by a dielectric sealing layer, called final passivation layer, through which interconnection wires are passed for connection with metal pads, called pads, external to the circuit structure 1 (wire bonding).

Although advantageous under many aspects, this circuit structure 1 has several drawbacks linked to the use of at least two different dielectric material layers between the conductive interconnection levels.

The technical problem underlying the present invention is to provide a circuit structure having such structural and functional features as to allow the performances of circuit structures having at least a double metalisation level to be improved, overcoming the limits and drawbacks still affecting prior art circuit structures.

### Summary of the invention

The solution idea underlying the present invention is to manufacture a circuit structure using a single dielectric layer between different conductive interconnection levels. This result is achieved by removing the different dielectric layers between the interconnection levels of traditional structures and insulating these interconnection levels by means of a single dielectric formed thereafter.

On the basis of this solution idea the technical problem is solved by a circuit structure as previously indicated and defined in the characterising part of claim 1.

The problem is also solved by a process as previously indicated and defined in the characterising part of claim 7.

The features and advantages of the circuit structure according to the invention will be apparent from the following description of an embodiment thereof given by way of non-limiting example with reference to the attached drawings.

### Brief description of the drawings

- Figure 1 is a sectional view of a portion of a circuit structure realised according to the prior art;
- Figure 2 is a picture from above of a last interconnection level of the structure of figure 1,
- Figures 3 to 6 are sectional views of a portion of a circuit structure realised according to the invention during the manufacturing steps thereof,
- Figure 7 is a picture from above of the circuit structure of figure 3,
- Figure 8 is a picture of a portion A of the circuit structure of figure 4.

### Detailed description

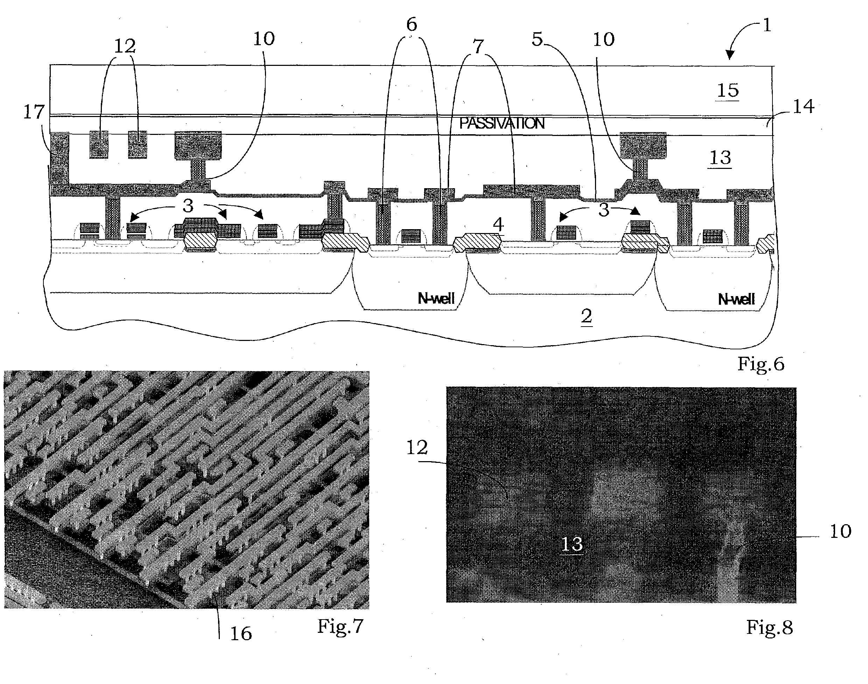

With reference to figure 6, a circuit structure 1 integrated on a semiconductor substrate 2 and a related manufacturing process are described.

The process steps described hereafter do not form a complete process flow for manufacturing integrated circuits. The present invention can be implemented together with the techniques for manufacturing integrated circuits presently used in this field and only those commonly used process steps which are necessary to understand the present invention are included in the description.

The figures representing cross sections of portions of a circuit structure during the manufacturing are not drawn to scale, but they are drawn instead in order to show the important features of the invention.

In particular, an electronic circuit structure 1 according to the invention, integrated on a semiconductor substrate 2, includes a plurality of electronic devices 3, for example transistors, formed on the semiconductor substrate 2.

The electronic components 3 are covered by a first dielectric layer 4, called pre-metal dielectric.

A closing layer 5, called stopping layer, covers the first dielectric layer 4 forming a thin continuous film. This closing layer 5 is realised for example with carbide or oxynitride or silicon nitride.

The first insulating layer 4 and the closing layer 5 comprise openings, called contact openings, located in correspondence with the conduction terminals of the electronic devices 3.

The openings are then filled in with a first conductive layer 6, for example a metallic layer, to put the electronic devices 3 into electrical communication with the circuit structure 1 outside.

A first interconnection level or layer is then realised on the closing layer 5 and on the first conductive layer 6 by means of a second conductive layer 7, for example a metallic layer.

According to the invention, a single insulating layer 13 is located between the first interconnection level and a following interconnection level or layer, i.e. the second interconnection level realised by means of a third conductive layer 12, for example a metallic layer.

The second interconnection level is electrically connected to the first interconnection level by means of a conductive layer 10, for example a metallic layer, passing through the insulating layer 13.

In particular, the single insulating layer 13 is planarised in order to let the second interconnection level appear.

The circuit structure 1 is then completed by means of a dielectric sealing layer 14, called final passivation layer.

The manufacturing method of the circuit structure 1 according to the invention is now described.

A plurality of electronic devices 3, for example transistors, resistors or diodes, are conventionally formed on a semiconductor substrate 2.

A first dielectric layer 4, for example of silicon oxide, is formed on all electronic devices 3.

A closing layer 5, called stopping layer, is deposited on this first dielectric layer 4. Openings are then realised in both these two layers 4, 5, located in correspondence with the conduction terminals of electronic devices 3.

This closing layer 5 is realised for example with carbide or silicon nitride.

The openings are then filled in with a first conductive layer 6, for example a metallic layer.

A first conductive interconnection level is then formed on the closing layer 5 and on the first conductive layer 6 by means of a second conductive layer 7, for example a metallic layer.

Nothing prevents the openings realised in the dielectric layers 4 and 5 from being filled in with the second conductive layer 7.

A second dielectric layer 8 is then formed on this first interconnection level.

The formation and following planarisation of this dielectric layer 8 are realised, for example, by forming an oxide layer and further forming an insulating layer 9 formed through the "Spin On Glass" technique and a further dielectric layer 11.

Alternatively, dielectric layers 8, 11, called intra/intermetal layers, are realised through the CVD (Chemical Vapour Deposition) technique followed by a CMP (Chemical Mechanical Polishing) planarisation step.

Openings filled in with a third conductive layer 10, for example a metallic layer, are then formed in these second and third intra/intermetal dielectric layers 8, 11; these openings being located in correspondence with predetermined portions of the first interconnection level.

A second interconnection level is realised on this latter dielectric layer 11 by means of a final conductive layer 12, for example a final metallic layer.

Advantageously, according to the invention, the circuit structure 1 is equipped with a frame 17 located between each interconnection level covering the whole periphery of the metallic structure 1 itself in order to confine the whole structure 1.

Advantageously, a plurality of supporting structures 16, shown in figure 7, of dielectric or conductive material are formed between the different interconnection levels in order to mechanically fasten the structures composing these interconnection levels to the premetal dielectric layer 4.

According to the invention, all intra/intermetal dielectric material layers 8, 11 between the interconnection levels up to the closing layer 5 are then removed.

This removal step can be performed through wet and/or dry chemical etching.

Advantageously, a following cleaning step with plasma, oxygen or the like or solvent removes possible polymeric residuals left by the preceding chemical etching for removing the intra/intermetal dielectric layers 8, 11.

Advantageously, a thin layer, non shown in the figures, is formed to coat the conductive interconnection levels through the CVD technique. This coating allows to prevent the diffusion of metal contaminations in successive insulating layers and vice versa. The thickness of this thin layer is comprised for example between 5 and 50 nm.

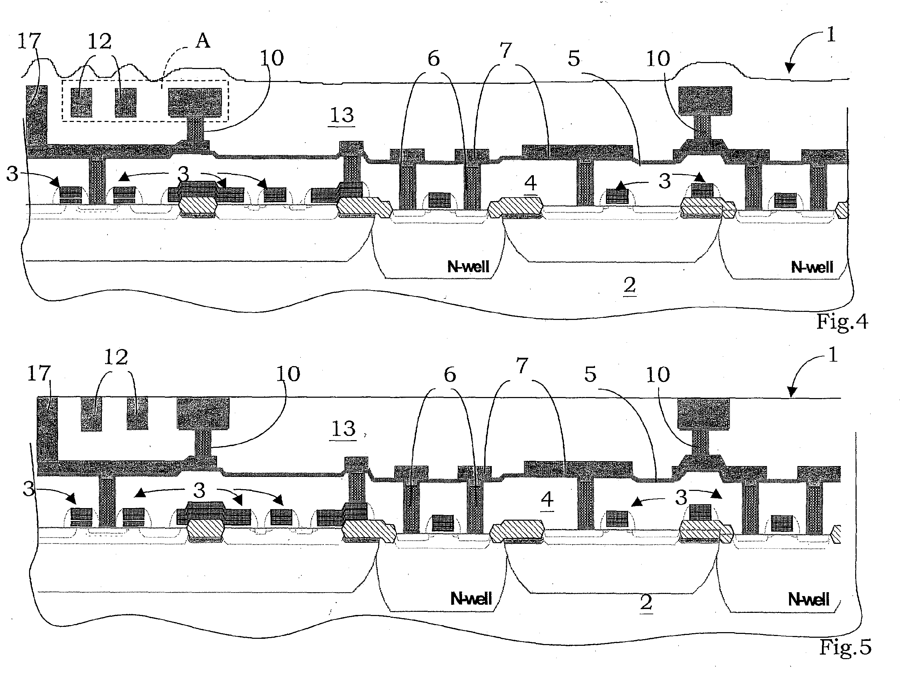

The portion of the circuit structure 1 left exposed between the interconnection levels is then filled in with an insulating layer 13 comprising a liquid material, for example through spinning, in bath or in a controlled pressure chemical deposition chamber and environment or similar techniques having the same function, up to cover the last interconnection level as shown in figure 4.

Advantageously, this filling step is performed through an underpressure filling step.

The liquid material used comprises, for example, solgels, aerogels, nanoporous, polyimides, SOGs, and it can be both of organic and inorganic type.

The material 13 can be advantageously an insulating material with low dielectric constant (low-k material).

This material is alternatively deposited through the spinning technique.

Advantageously, if a frame has been realised along the periphery of the circuit structure 1, this serves as frame 17 or containment tank for the liquid material in order to fill in the interconnection levels starting from the closing layer 5.

The liquid material thus inserted by capillarity or under pressure is then densified, for example by baking, in predetermined temperature, time, pressure and environment conditions.

Advantageously, the circuit structure 1 is recognisable by the absence of interfaces, which would be otherwise noted if the traditional intermetal planarising technique, being previously described as prior art, would be used. In fact the insulating layer 13 is formed by a single material layer, as shown in figures 6 and 8.

The layer 13 is then planarised, for example through the wet or dry etch technique or the chemical mechanical polishing with slurry or dry polishing up to expose the upper surface of the last interconnection level. A surface cleaning (scrubber) step of the layer 13 can then follow.

The circuit structure 1 is then sealed with deposited final passivation layers 14, for example, through chemical vapour deposition (oxide, oxynitride, nitride, silicon carbide, PSG, FSG, etc.) and possibly with a Buffer Coating layer 15 to provide the necessary mechanical resistance of the circuit structure 1 and thus compensate for the preceding removal of intra/intermetal dielectric layers 8, 11, usually mechanically more resistant than a SOG or a low-k material.

Metal pads are then realised in a conventional way by traditional masking. These metal pads realised through the final CVD passivation dielectric 14 can have already been opened before depositing the Buffer Coating layer 15.

In conclusion, the process according to the invention allows a single dielectric layer 13 to be used between the different interconnection levels allowing the intermetal and intrametal dielectric constant to be united in order to allow the "delay time" RC constant for the circuit structure 1 at the electrical simulation level to be calculated more accurately.

Moreover, it is possible to use low dielectric constant materials 13 without problems of moisture absorption, of process integration (for example vias etching) and of adhesion between the various insulating layers. This solution, in normal circuit architectures, usually requires "barrier" layers on and under this insulating material thus implying a higher number of process steps and difficulties.

The importance of exploiting these low dielectric constant materials is in fact more and more important as it appears from the searches carried out in the attempt of using substances with a constant being closer and closer to 1 by means of gas.

Moreover, from the structural point of view, the circuit structure according to the invention, by using a single dielectric layer, is not affected by adhesion and/or interface compatibility problems, as it happens in conventional circuit structures.

Moreover, in the whole description reference has been made only to two interconnection levels, but the circuit structure 1 and the process according to the invention can be advantageously used in circuit structures 1 having a higher number of interconnection levels.

## Claims

1. A circuit structure (1) integrated on a semiconductor substrate (2) comprising a plurality of electronic devices (3) covered by a first insulating layer (4) **characterised in that** said first dielectric layer (4) is covered by a closing layer (5) whereon a plurality of conductive interconnection levels are realised, being electrically connected to each other and separated from each other by means of a single insulating layer (13).

2. A circuit structure (1) according to claim 1, **characterised in that** a frame is realised along the periphery of said circuit structure (1) in correspondence with each conductive interconnection level.

3. A circuit structure (1) according to claim 1, **characterised in that** each interconnection level is fastened to the underlying interconnection level by means of auxiliary structures.

4. A circuit structure (1) according to claim 1, **characterised in that** these insulating layers (4, 13) are silicon dielectrics.

5. A circuit structure (1) according to claim 1, **characterised in that** said insulating structure (13) is a low dielectric constant layer.

6. A circuit structure (1) according to claim 1, **characterised in that** said closing layer (5) is an oxynitride, nitride, silicon carbide layer.

7. A manufacturing process of a circuit structure (1) integrated on a semiconductor substrate including a plurality of electronic devices (3) comprising at least the step of:
- forming a first insulating layer (4) on said plurality of electronic devices (3), the process being **characterised in that** it comprises the further following steps:
- forming a closing layer (5) on said first insulating layer (4);
- forming a first conductive interconnection layer on said closing layer (5);
- forming a plurality of dielectric layers (8, 11) on said first conductive interconnection layer,
- forming a second conductive interconnection layer on said plurality of dielectric layers (8, 11);
- removing said plurality of dielectric layers (8, 11),
- separating said conductive interconnection layers from each other by means of a single dielectric layer (13).

8. A manufacturing process according to claim 7, **characterised in that** said insulation step is performed by inserting a liquid insulating material (13), between said conductive interconnection layers.

9. A manufacturing process according to claim 8, **characterised in that** said material (13) in the liquid phase is densified through baking.

10. A manufacturing process according to claim 8, **characterised in that** said insertion step of this material (13) in the liquid phase is preceded by a wet or dry cleaning step.

11. A manufacturing process according to claim 8, **characterised in that** said insertion step of this material (13) in the liquid phase is preceded by a step for forming a thin dielectric layer on said conductive interconnection layers in order to avoid the diffusion of conductive particles contaminations in the insulator and vice versa.

12. A manufacturing process according to claim 7, **characterised in that** said liquid insulating material (13) is inserted under pressure.

13. A manufacturing process according to claim 7, **characterised in that** said liquid insulating material (13) is inserted by capillarity.

14. A manufacturing process according to claim 7, **characterised in that** said plurality of dielectric layers (8, 11) can be selectively etched with respect to said closing layer (5).
